# EUROPEAN PATENT APPLICATION

(11) **EP 1 780 880 A2**
(43) Date of publication of application: **02.05.2007**
(21) Application number: 06020010.2
(22) Date of filing: 25.09.2006
(51) Int. Cl.: H02M 3/00

(54) **Power converter comprising a controller and a power component mounted on separate circuit boards**

(30) Priority: 25.10.2005 US 258509
(71) Applicant: Hewlett-Packard Development Company, L.P., Houston, TX 77070 (US)
(72) Inventor: Lin, Richard S., Houston, Texas 77070 (US); Jabori, Monji G., Houston, Texas 77070 (US); Sawyers, Thomas P., Houston, Texas 77070 (US)
(74) Representative: Schoppe, Fritz

(57) **Abstract**

In at least some embodiments, a power converter (50) comprises control logic (56) adapted to be mounted on a first circuit board (60) and a power component adapted to be electrically coupled to the control logic (56) and adapted to be mounted on a second circuit board (62). The first circuit board (60) mechanically attaches to the second circuit board (62). In other embodiments, a system comprises a system board, a module attached to the system board, and a power converter (50) comprising a controller electrically coupled to a power component. The controller is mounted on the module and the power component is mounted on the system board.

## Description

### BACKGROUND

Power converters are used in a variety of applications including computers. In general, power converters convert an input voltage to an output voltage at a different voltage level. For example, a power converter might convert a 12 volt direct current ("VDC") voltage to a 3.3 VDC output voltage.

A power converter typically includes low voltage control circuitry and higher power circuitry. The power circuitry comprises one or more components (e.g., transistor) through which some or all of the electrical output current flows. As a result, the power circuitry becomes warmer than the control circuitry and even hot to the touch and thus benefits from thermal control mechanisms to remove the generated heat. Removing heat from electronics can be problematic particularly in some instances. For example, a portable electronic device, such as a laptop computer, by design is small and compact and thus has little empty space for moving air over the electronics. Further, because of noise and size constraints in a laptop, the fan, if there is a fan, is typically small and generally incapable of moving a sufficient volume of air. As a result, maintaining a portable electronic device such as a laptop in a thermally benign state can be problematic. Accordingly, cooling the power converter's power circuitry can be difficult.

Another problem that faces system designers is addressing a change to a circuit board design (e.g., a "mother" board). Such a change may result if a provider of a circuit board designs the board for a certain part (e.g., a controller chip) and, after the board is designed and tested, changes to another part that is not pin compatible with the board designed for the initial part. The decision to change to such a pin-incompatible part may stem from a variety of reasons. For example, a vendor of the original part may no longer supply the part, forcing the board manufacturer to switch to a replacement part. For whatever reason, a different, pin-incompatible part is to be used in conjunction with a circuit board that has already been designed for another part; the change in parts necessitates a design change to the circuit board. In the case of a mother board in a computer, for example, this design change can be extensive and expensive.

### BRIEF DESCRIPTION OF THE DRAWINGS

For a detailed description of exemplary embodiments of the invention, reference will now be made to the accompanying drawings in which:

Figure 1 shows an exemplary circuit embodiment of a power converter;

Figures 2 and 3 illustrate an exemplary manner in which various portions of a power converter circuit can be separately mounted;

Figure 4A shows a top view of a control portion of a power converter;

Figure 4B shows a plan, cut-away view of the power converter of Figure 4A mounted on a power portion of the power converter;

Figure 5A shows an alternative top view of a control portion of a power converter;

Figure 5B shows a plan, cut-away view of the power converter of Figure 5A mounted on a power portion of the power converter;

Figure 6A shows yet another alternative top view of a control portion of a power converter; and

Figure 6B shows a plan, cut-away view of the power converter of Figure 6A mounted on a power portion of the power converter.

### NOTATION AND NOMENCLATURE

Certain terms are used throughout the following description and claims to refer to particular system components. As one skilled in the art will appreciate, computer companies may refer to a component by different names. This document does not intend to distinguish between components that differ in name but not function. In the following discussion and in the claims, the terms "including" and "comprising" are used in an open-ended fashion, and thus should be interpreted to mean "including, but not limited to...." Also, the term "couple" or "couples" is intended to mean either an indirect or direct electrical connection. Thus, if a first device couples to a second device, that connection may be through a direct electrical connection, or through an indirect electrical connection via other devices and connections. The term "system" refers to a collection of two or more parts. The term "system" may be used to refer to a computer system on a portion of a computer system.

### DETAILED DESCRIPTION

The following discussion is directed to various embodiments of the invention. Although one or more of these embodiments may be preferred, the embodiments disclosed should not be interpreted, or otherwise used, as limiting the scope of the disclosure, including the claims. In addition, one skilled in the art will understand that the following description has broad application, and the discussion of any embodiment is meant only to be exemplary of that embodiment, and not intended to intimate that the scope of the disclosure, including the claims, is limited to that embodiment.

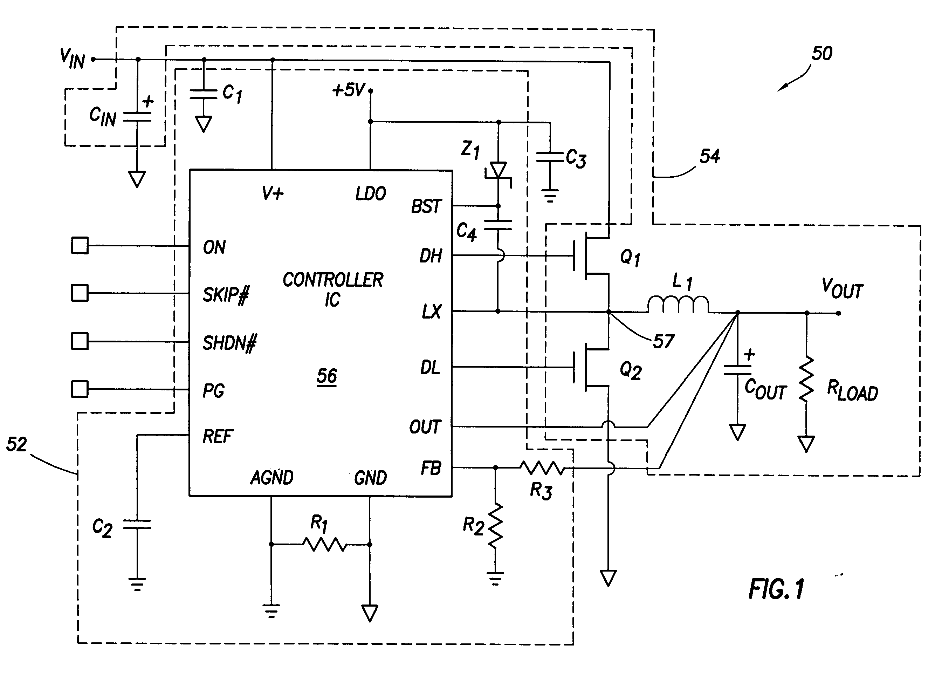

Figure 1 shows an exemplary circuit embodiment of a power converter 50. As shown, the power converter 50 comprises at least two portions-a control portion 52 and a power portion 54. The control and power portions are electrically coupled together as shown. The control portion 52 comprises control logic including controller 56 and one or more discrete passive components. The passive components of the embodiment of Figure 1 include capacitors C1, C2, C3 and C4, diode Z1, and resistors R1, R2 and R3. The power portion 54 comprises power transistors Q1 and Q2, inductor L1, capacitor COUT, and resistor RLOAD. In general, the power portion 54 comprises at least one power component and in some embodiments, such as that shown in Figure 1, comprises a plurality of power components and, as appropriate, other components. A power component refers to a component through which electrical current flows to a load. The power converter 50 shown in Figure 1 can be used in a system such as a computer system and, as such, the converter 50 provides power to one or more loads (not specifically shown) in the system.

The controller 56 comprises a pulse width modulator ("PWM") control chip, such as the MAX1999EEI controller provided by MAXIM. The controller 56 generally is used to receive an input DC voltage ("VIN") and generate an output constant voltage level ("VOUT") that, in at least some embodiments, is less than the input voltage. For example, VIN may be +12VDC and VOUT may be +3.3VDC. The controller 56 may be implemented as a dual controller capable of providing two, possibly different, output voltages (e.g., +1.5VDC and +3.3VDC). In general, the controller 56 can be implemented so as to provide any suitable number of output voltages.

The controller 56 depicted in Figure 1 has a plurality of inputs and outputs. The controller's inputs and outputs are listed in Table I below with a brief description of each signal. Other signals are shown in Figure 1 associated with controller 56, but are not used in the embodiment of Figure 1. Such signals are included in Table I.

**TABLE I. Inputs/Outputs of Controller 56**

| **Signal Name** | **I/O** | **Description** |
|---|---|---|
| V+ | I | Battery Voltage-Sense Connection |
| VDD/VL | I/O | Supply Input / 5V LDO |
| DH | O | High Side Gate Driver |
| DL | O | Low Side Gate Driver |
| LX | O | Inductor Connection |
| OUT | I | Output Voltage Sense |
| FB | I | Feedback input |
| REF | O | Reference voltage output |
| AGND, GND | I | Analog and power grounds |
| ON | I | Out |
| SKIP | I | Pulse-skipping control input |
| PGOOD | O | Power good open-drain output |

As shown in Figure 1, the circuit topology used is a synchronous-buck converter in which the two power transistors Q1 and Q2 (also referred to as "upper" and "lower" transistors, respectively), connected in series between the DC input source ("VIN") and ground are driven alternately on and off in one switching cycle. The controller 56 generates "high" and "low" control signals ("DH" and "DL") that reciprocally cause the transistors Q1 and Q2 to turn on and off out of phase with respect to each other. That is, when Q1 is turned on, Q2 is turned off, and vice versa. The duty cycle at which the transistors are turned on and off is effectuated by the controller 56 so as to attain the desired VOUT voltage level. As a result of the oscillatory and coordinated action of transistors Q1 and Q2, the voltage at the node interconnecting the two transistors (node 57) comprises a switching waveform. As such, node 57 is called the "switching" node. The switching node 57 provides the switching waveform to a low pass filter comprising inductor L1 and capacitor C_{OUT} that averages the switching voltage to the desired DC output voltage (VOUT). The controller 56 constantly regulates the duty cycle associated with the transistors Q1 and Q2 based on signals received at the controller's OUT and FB input terminals. The various capacitors, resistors and diode shown in the control portion 52 of the power converter 50 permit the controller 56 to operate correctly. For example, resistors R2 and R3 form a voltage divider network for the FB input terminal.

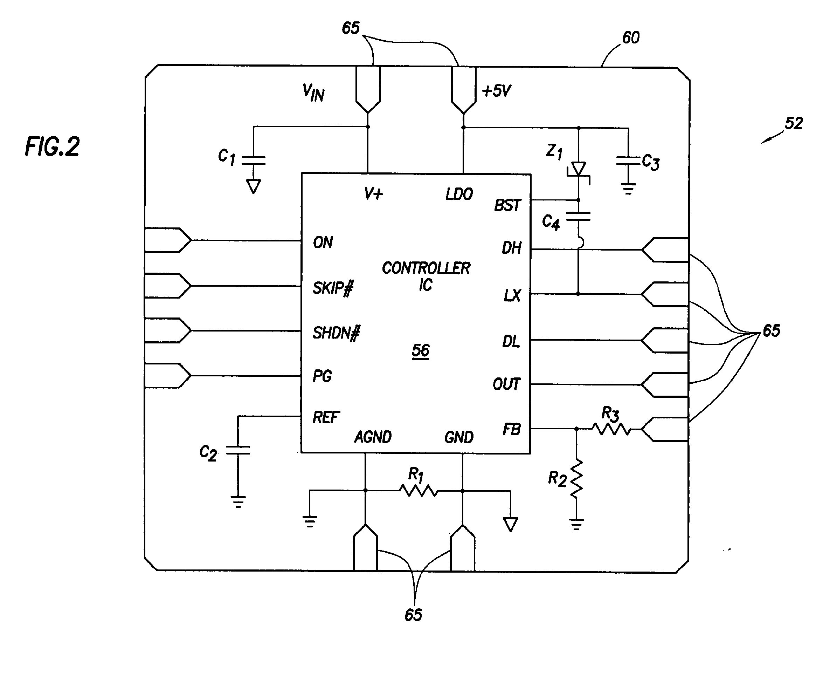

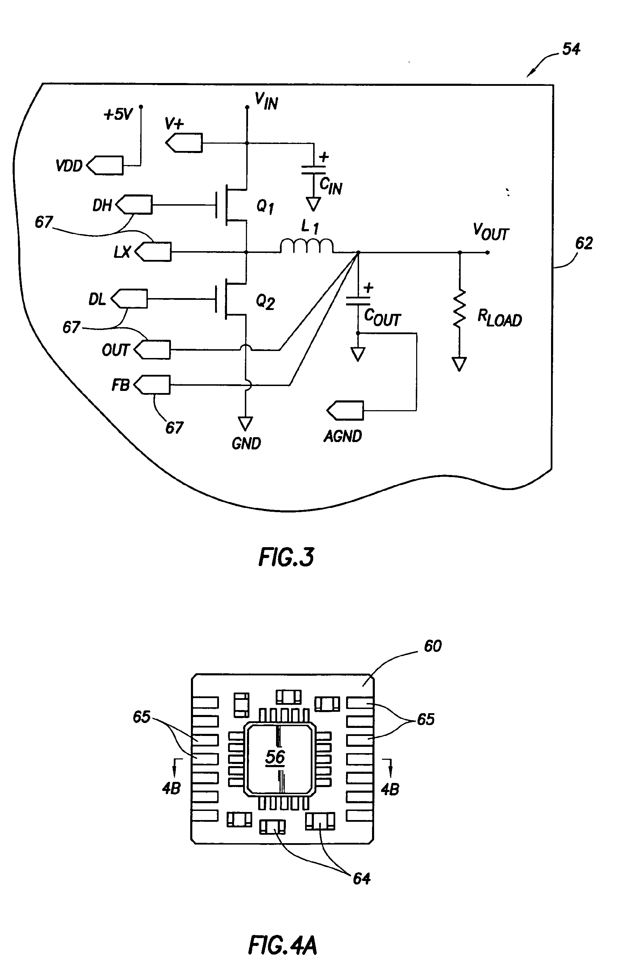

In accordance with an exemplary embodiment of the invention, the control portion 52 containing the control logic and the power portion 54 containing at least one power component are manufactured on two separate circuit boards or modules. In the context of a computer system, for example, the power portion 54 is provided on the computer's mother board and the control portion 52 is provided on a "daughter" board that is mechanically and electrically attachable to the mother board. Figures 2 and 3 illustrate an exemplary layout division of the components of Figure 1 that comprise the power converter 50. Figure 2 shows a first circuit board 60 on which the components of the control portion 52 are mounted. Conductive terminals 65 are provided to permit connections between the control logic of the control portion 52 and one or more power components of the power portion 54. Figure 3 shows at least a portion of a second circuit board 62 on which the power portion components are mounted. Terminals 67 are provided to permit electrical connections between components of the power portion 54 and one or more components of the control portion 52.

As noted above, in some embodiments, the second circuit board 62 may comprise a computer's mother board. By providing the power portion 54 on a computer's mother board, such components, which tend to become warmer than various other components in the computer (such as those in the control portion 52), can often be more efficiently cooled using the thermal conditioning mechanisms (e.g., fan) of the computer. By providing the control portion 52 on a separate board, such as a daughter board, any board design changes necessitated by a change in the control portion circuitry (e.g., a change to a different controller 56) only necessitates a change in the daughter board, not the mother board. A design change to the daughter board is generally less involved and less costly than a change to the computer's mother board.

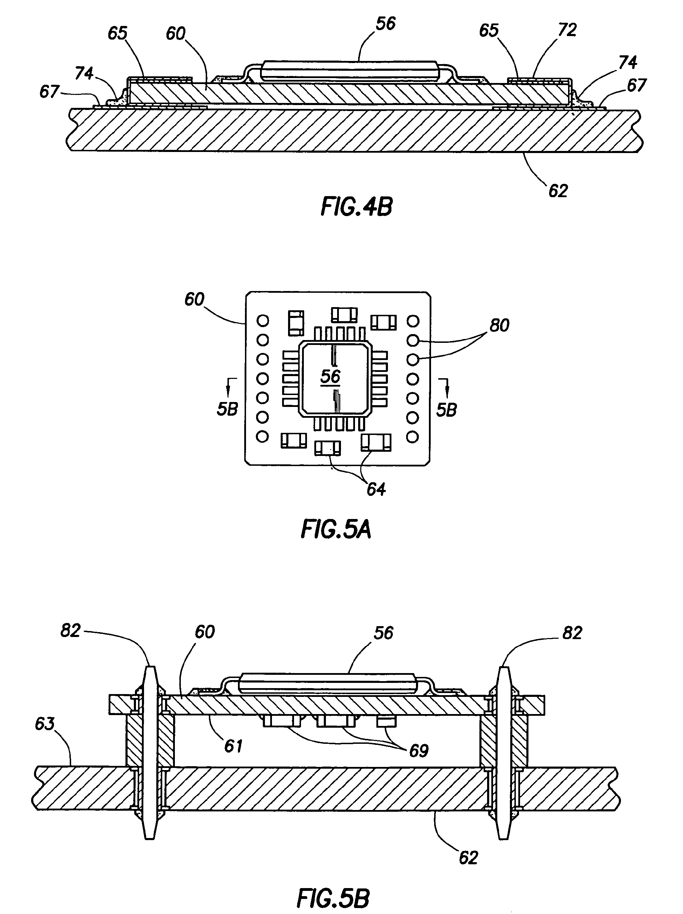

Figure 4A shows a top layout view of the control portion 52 of the power converter. As shown, the control portion comprises the controller 56 and various passive components 64 mounted on the first circuit board 60. The passive components 64 comprise any or all of the resistors, capacitors, and diode of the control portion 52 shown in Figures 1 and 2. The first circuit board 60 may comprise a daughter board mounted on a mother board 62 (Figure 4B) by way of one or more electrically conductive copper fingers 72. Copper fingers 72 wrap around the edges of the board 60 and are in electrical contact with the conductive pads 65. Through the use of solder 74, the copper fingers 72, and thus the conductive pads 65, are electrically connected to corresponding conductive pads 67 on the mother board 62. Although not specifically shown in Figure 4B, the power portion components are mounted on the mother board 62.

Figures 5A and 5B show an alternative configuration in which the daughter board 60, which contains the control portion 52, is attached to the mother board 62, which contains the power portion 54, by way of electrically conductive header pins 82. The daughter board 60 contains a plurality of through-holes 80 formed therein through which the header pins 82 are inserted and soldered, thereby electrically connecting one or more components of the control portion 52 to one or more components of the power portion 54. By mating the first circuit board 60 (daughter board) to the second circuit board (mother board 62), the first circuit board 60 can be raised off the surface 63 of the second circuit board. In this way, electrical components 69 such as control-related components can be mounted on the underneath surface 61 of the first circuit board 60 as shown. The electrical components 69 may include one or more of the components shown in Figure 1 as comprising the control portion 52. By mounting control portion components on both surfaces of the daughter board 60, the surface area of the daughter board can be made smaller than a daughter board on which components are mounted on only a single surface.

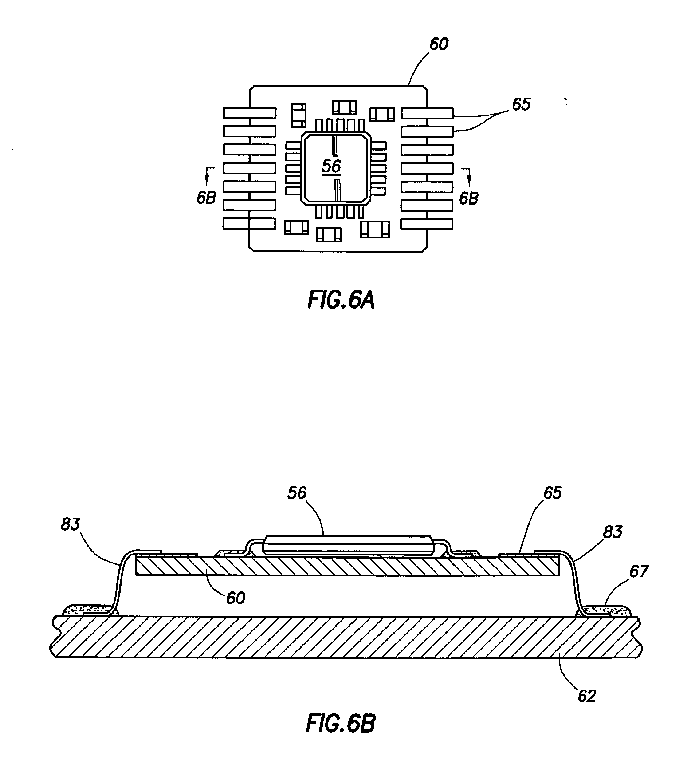

Figures 6A and 6B illustrate yet another embodiment in which the daughter board 60 is mounted on the mother board 62 by way of solder-on-leads 83. Leads 83 solder to conductive pads of daughter board 60 and to corresponding conductive pads 67 of mother board 62.

The above discussion is meant to be illustrative of the principles and various embodiments of the present invention. Numerous variations and modifications will become apparent to those skilled in the art once the above disclosure is fully appreciated. It is intended that the following claims be interpreted to embrace all such variations and modifications.

## Claims

1. A power converter (50) adapted to provide power to a load, comprising:
control logic (56) adapted to be mounted on a first circuit board (60); and
a power component adapted to be electrically coupled to the control logic (56) and adapted to be mounted on a second circuit board (62), wherein at least some of said power flows through said power component (L1) to said load;
wherein said first circuit board (60) mechanically attaches to the second circuit board (62).

2. The power converter (50) of claim 1 wherein the control logic (56) comprises a pulse width modulator ("PWM") controller and a plurality of passive components (C1, C2, C4, R1, R2) coupled to the PWM controller.

3. The power converter (50) of claim 1 further comprising a plurality of power components that are adapted to be electrically coupled to the control logic (56) and adapted to be mounted on the second circuit board (62).

4. The power converter (50) of claim 1 wherein the power component comprises a component selected from a group consisting of a power transistor, an inductor (L1), and a power capacitor.

5. The power converter (50) of claim 1 wherein the power component is adapted to be at least partially covered by the first circuit board (60).

6. The power converter (50) of claim 1 wherein the second circuit board (62) comprises a mother board for use in a computer system and the first circuit board (60) comprises a daughter board.

7. The power converter (50) of claim 1 wherein the first circuit board (60) mechanically and electrically attaches to said second circuit board (62) by way of electrically conductive header pins (82).

8. The power converter (50) of claim 1 wherein the first circuit board (60) mechanically and electrically attaches to said second circuit board (62) by way of electrically conductive figures (72) that wrap around edges of the first circuit board (60).

9. The power converter (50) of claim 1 wherein the first circuit board (60) mechanically and electrically attaches to said second circuit board (62) by way of solder-on-leads (83) soldered to conductive pads of both the first and second circuit boards (60, 62).
